Europäisches Patentamt

European Patent Office

Office européen des brevets

(19)

(11) Veröffentlichungsnummer: **0 438 103 A2**

(12) **EUROPÄISCHE PATENTANMELDUNG**

(21) Anmeldenummer: **91100377.0**

(22) Anmeldetag: **14.01.91**

(51) Int. Cl.5: **G01R 27/26**

(30) Priorität: **15.01.90 DE 4000946**
**14.01.91 DE 4100869**

(43) Veröffentlichungstag der Anmeldung:
**24.07.91 Patentblatt 91/30**

(84) Benannte Vertragsstaaten:
**DE FR GB**

(71) Anmelder: **Weiss, Dieter, Dr.**
**Porphyrstrasse 15**
**W-6905 Schriesheim(DE)**

(72) Erfinder: **Weiss, Dieter, Dr.**
**Porphyrstrasse 15**
**W-6905 Schriesheim(DE)**

(74) Vertreter: **Geyer, Ulrich F., Dr. Dipl.-Phys. et al**
**WAGNER & GEYER Patentanwälte**
**Gewuerzmuehlstrasse 5 Postfach 246**
**W-8000 München 22(DE)**

(54) **Verfahren und Vorrichtung zum Messen physikalischer Grössen.**

(57) Bei dem Verfahren zum Messen physikalischer Größen wird ein periodisches Speisesignal abgegeben und ein Antwortsignal ausgewertet. Das Speisesignal weist dabei eine vorgegebene Signalform auf, und das Antwortsignal wird während wenigstens einer Signalperiode an wenigstens einem diskreten Zeitpunkt abgefragt. Der wenigstens eine diskrete Abfragewert wird ausgewertet. Dieses Meßverfahren erlaubt eine sehr hohe Meßgeschwindigkeit bei der Meßwertaufnahme, insbesondere im Zusammenhang mit Kapazitiv-, Induktiv- und widerstandsgebern, so daß dieses Meßverfahren insbesondere auch für die Messung physikalischer Parameter während schneller Prozeßabläufe in der Verfahrenstechnik und während der Produktion besonders gut geeignet ist. Der Abfragezeitpunkt ist vorzugsweise im zeitlichen Bezug zum Speisesignal gewählt. Dadurch ist auf einfache Weise die getrennte Messung sowohl des Real- als auch des Imaginärteils komplexer Widerstände mit hoher Geschwindigkeit möglich.

EP 0 438 103 A2

# VERFAHREN UND VORRICHTUNG ZUM MESSEN PHYSIKALISCHER GRÖSSEN

Die Erfindung betrifft ein Verfahren zum Messen physikalischer Größen, bei dem ein periodisches Speisesignal abgegeben und ein Antwortsignal ausgewertet wird. Die Erfindung betrifft weiterhin eine Vorrichtung zur Durchführung des Verfahrens.

Bei herkömmlichen Meßverfahren und -vorrichtungen dieser Art zum Messen von Kapazitäten, Induktivitäten und Widerständen werden einem Geber sinusförmige Signale eingespeist. Die Messung der Kapazitäten, Induktivitäten oder Widerstände erfolgt durch die Ermittlung der Phasenverschiebung zwischen dem eingespeisten Signal und dem Antwortsignal. Dieses Verfahren, das auch als Trägerfrequenzverfahren bezeichnet wird, hat jedoch den Nachteil, daß für die Ermittlung der Phasenlage Filter erforderlich sind, die die Meßfrequenz erniedrigen. Darüber hinaus ist die Meßwertauflösung auf Grund des nicht zu vermeidenden Restbrumms gering und auch mit hohem schaltungstechnischem Aufwand nicht zu verbessern.

Insbesondere in der heutigen Verfahrenstechnik wird es immer wichtiger, bei laufendem Prozeß die physikalischen Parameter und Größen der produzierten Produkte sehr schnell zu ermitteln, um den Ausschuß zu verringern und die Produktivität der Anlagen zu erhöhen.

Als Beispiel für derartige Herstellungsverfahren sei die Produktion von Kupferdrähten für die Elektronik genannt. Während des sehr schnellen Kupferdraht-Durchlaufs muß die Dicke der Lackbeschichtung ständig ermittelt und in Abhängigkeit davon der Beschichtungsvorgang gesteuert werden. Um die Dicke der Lackbeschichtung zu bestimmen, wird die Kapazität der Lackschicht gemessen. Die Kapazitätsänderungen sind jedoch sehr klein und die Meßgeschwindigkeit muß bei den hohen Produktionsgeschwindigkeiten sehr hoch sein. Die herkömmlichen Meßverfahren sind nur in begrenztem Maße zur Lösung derartiger Aufgaben geeignet.

Ein weiteres Beispiel für den Einsatz von schnellen und sehr empfindlichen Meßverfahren sind Hydropulsanlagen zur Ermittlung der physikalischen Eigenschaften von Polymeren. Bei derartigen Hydropulsanlagen wirkt eine Kraft mit einer Frequenz bis zu einigen kHz auf das zu untersuchende Material ein. Die einwirkende Kraft wird dann in Relation zur Verformung gesetzt. Aus der Phasenverschiebung zwischen dem Speise- und dem Antwortsignal können dann Aussagen über die Materialeigenschaften gewonnen werden. Bei Verwendung des herkömmlichen Trägerfrequenzverfahrens ist die Meßgenauigkeit und die Meßgeschwindigkeit begrenzt, da das damit verbundene Längenmeßverfahren selbst einen dem Meßverfahren inhärenten Phasengang aufweist, wodurch die eigentliche Messung verfälscht wird.

Auch bei der Produktion von Kunstfasern, insbesondere von Carbonfasern, muß bei laufender Produktion die Kapazität sowie die Dämpfung der Faser schnell und bei kleinen Kapazitäts- und Dämpfungswerten ermittelt werden. Dabei ist es mit herkömmlichen Meßverfahren nicht möglich, den Real- vom Imaginärteil eines komplexen Widerstands meßverfahrensmäßig zu trennen, was für derartige Meßvorgänge in der Verfahrenstechnik mit schnellen Prozeßabläufen von sehr großer Bedeutung ist.

Der Erfindung liegt daher die Aufgabe zugrunde, ein Verfahren zum Messen physikalischer Größen und eine Vorrichtung zur Durchführung eines solchen Verfahrens anzugeben bzw. zu schaffen, mit dem bzw. mit der auch kleine physikalische Größen oder Größenänderungen sehr schnell gemessen werden können. Ausgehend von dem eingangs angegebenen Verfahren wird diese Aufgabe dadurch gelöst, daß das Speisesignal eine vorgegebene Signalform aufweist und das Antwortsignal während wenigstens einer Signalperiode an wenigstens einem diskreten, vorgegebenen Punkt abgefragt und der wenigstens eine diskrete Abfragewert ausgewertet wird.

Mit den erfindungsgemäßen Maßnahmen ist es möglich, den Meßwert innerhalb einer Periode des Speisesignals bereitzustellen. Ein weiterer wesentlicher Vorteil besteht darin, daß Filter im Gegensatz zu herkömmlichen Meßverfahren, etwa dem Trägerfrequenzverfahren, nicht erforderlich sind. Auf diese Weise läßt sich die Meßgeschwindigkeit wesentlich erhöhen. Weiterhin ist die Meßwertauflösung bei dem erfindungsgemäßen Verfahren besser, weil ein Filter und damit ein Restbrumm nicht vorhanden ist.

Das erfindungsgemäße Verfahren ist universell zum Messen physikalischer Größen verwendbar und insbesondere geeignet, die Signale aller üblichen passiven Geber (DMS, Differential-Trafos, kapazitiver Meßbrücken usw.) auszuwerten und zu verarbeiten. Dabei ist das Verfahren nicht nur in der Meßtechnik, wie beispielsweise im Zusammenhang mit marktüblichen Induktivgebern zur Messung von Wegen mit Auflösungen im Nanometer-Bereich, einsetzbar. Besonders vorteilhaft anwendbar ist das erfindungsgemäße Verfahren insbesondere in der Verfahrenstechnik, um bei schnellen, laufenden Fertigungsprozessen die physikalischen Eigenschaften von Stoffen, Flächenbelägen, Ohm'sche Verluste, Dielektrizitätskonstanten usw. zu ermitteln, um in Abhängigkeit davon den Produktionsablauf optimal steuern bzw. regeln zu können.

Gemäß einer sehr vorteilhaften Ausgestaltung der Erfindung ist der Abfragezeitpunkt im zeitlichen Bezug zum Speisesignal gewählt. Auf diese Weise ist es möglich, mit demselben Meßverfahren und derselben Meßanordnung durch entsprechende Wahl der Abfragezeitpunkte, die in zeitlichem Bezug zum Speisesignal stehen, den Real- und Imaginärteil des zu messenden, komplexen Widerstands jeweils getrennt zu ermitteln. Die dadurch geschaffene Möglichkeit, den Imaginärteil des zu messenden, komplexen Widerstands vom Realteil getrennt zu erhalten, ist insbesondere dann von großem Vorteil, wenn etwa langzeitig auftretende Schwankungen im Realteil der Meßwerte, beispielsweise der Temperaturgang einer Induktivität, kompensiert werden muß.

Von besonderem Vorteil ist in diesem Fall, wenn der Abfragezeitpunkt in zeitlichem Bezug zu einem Nulldurchgang des Speisesignals steht. Von besonderem Vorteil ist dabei, wenn das Antwortsignal beim Nulldurchgang des Speisesignals abgefragt wird. Wie im nachfolgenden anhand der Ausführungsbeispiele noch im einzelnen erläutert werden wird, fließt beim Nulldurchgang des Speisesignals in einer Induktivität kein Strom, so daß auch Ohm'sche Verluste und damit Änderungen auf Grund von Temperaturschwankungen nicht auftreten können. Beim Abfragen des Antwortsignals zum Zeitpunkt des Nulldurchgangs des Speisesignals wird daher nur der Imaginärteil des komplexen Widerstands gemessen.

Gemäß einer besonders vorteilhaften Ausführungsform der Erfindung ist das Speisesignal eine im wesentlichen dreieckförmige periodische Spannung. Dies ist insbesondere dann von Vorteil, wenn das Verfahren im Zusammenhang mit einem Kapazitiv-Geber verwendet wird.

Insbesondere bei Verwendung eines Induktiv-Gebers ist es vorteilhaft, als Speisesignal einen im wesentlichen dreieckförmigen Strom zu verwenden.

Ist ein Widerstandsgeber vorgesehen, sollte das Speisesignal vorzuweise im wesentlichen ein rechteckförmige Spannung sein. Da Kapazitiv-, Induktiv- und/oder Widerstandsgeber im praktischen Falle auch entsprechende andere Widerstandsanteile aufweisen, also keine reinen induktiven, kapazitiven und /oder Widerstandsgeber sind, ist es von besonderem Vorteil, wenn das Speisesignal eine Mischform ist. Vorteilhafterweise kann das Speisesignal trapezförmig sein. Der ansteigende Teil des trapezförmigen Speisesignals wird dabei vorzugsweise zur Ermittlung des Imaginärteils und der flache Teil zur Ermittlung des Realteils des komplexen Widerstands herangezogen. Bei einem Induktiv-Geber läßt sich dadurch trotz eines nicht zu vermeidenden Anteils des Ohm'schen Widerstands der Spule, ein rechteckförmiges Antwortsignal erzielen.

Von besonderem Vorteil ist es, wenn die Form des Speisesignals so gewählt und/oder geändert wird, daß das Antwortsignal rechteckförmig ist bzw. bleibt. Die entsprechende Form des Speisesignals wird also in Abhängigkeit der gegebenen, gegebenenfalls sich auch ändernden Verluste, etwa durch entsprechende Kombination von Rechteck- und Dreieckanteilen so geändert, daß das Antwortsignal rechteckförmig ist. Ein rechteckförmiges Antwortsignal hat den Vorteil, daß die Abfragewerte leicht erhalten und ausgewertet werden können.

Gemäß einer vorteilhaften alternativen Ausführungsform der Erfindung wird die Form des Antwortsignals ausgewertet. In diesem Falle kann das Speisesignal konstant belassen werden, und lediglich die Form des Antwortsignals wird mittels der diskreten Abfragewerte ausgewertet bzw. ermittelt.

Besonders vorteilhaft ist es, wenn das Antwortsignal während einer Periode des Speisesignals an mehreren Zeitpunkten abgefragtwird. Die Auswertung der Abfragesignale ermöglicht dadurch die im wesentlichen gleichzeitige und voneinander getrennte Ermittlung des Real- und Imaginärteils eines komplexen Widerstands.

Eine sehr vorteilhafte Ausführungsform der Erfindung besteht darin, daß das Antwortsignal während wenigstens einer Periode an wenigstens zwei Punkten abgefragt und die Abfragewerte gemittelt und/oder die Differenz aus den Abfragewerten gebildet wird. Gemäß dieser Ausführungsform des erfindungsgemäßen Verfahrens ergibt sich der Realteil aus der Mittelung der beiden Abfragewerte und der Imaginärteil aus der Differenz derselben. Diese Ausführungsform stellt eine besonders vorteilhafte Möglichkeit zur getrennten Ermittlung des Imaginär- und des Realteils des zu messenden komplexen Widerstands dar.

Insbesondere im Zusammenhang mit den Ausführungsformen, bei denen das Antwortsignal während einer Periode des Speisesignals an wenigstens zwei Punkten abgefragt werden, ist es besonders vorteilhaft, die Abfragewerte zur Ermittlung von Materialeigenschaften auszuwerten. Vorzugsweise wird durch die Auswertung der Abfragesignale die Art des Materials und/oder die Qualität bestimmt. Beispielsweise kann durch die Bildung der Differenz aus den Abfragewerten, also durch Ermittlung des Imaginärteils, die Art des Materials ermittelt und/oder durch die Mittlung der Abfragewerte, also des Realteils, die Menge des vorliegenden Materials festgestellt werden. Es sind jedoch auch andere Auswertealgorithmen anwendbar.

Gemäß einer vorteilhaften Ausführungsform, insbesondere im Zusammenhang mit der Ermittlung des Real- und des Imaginärteils, wird das zu prüfende Material in einem Plattenkondensator gebracht, der mit einer dreieckförmigen Spannung beaufschlagt wird. Zur Durchführung eines kontinuierlichen Prozesses durchläuft das Material den Plattenkondensator vorteilhafterweisekontinuierlich.

Als eine besonders vortgeilhafte Ausführungsform des Verfahrens wird eine Papierbahn durch den Plattenkondensator geführt. Durch die entsprechende Auswertung ist es dabei möglich, festzustellen, ob und welche Stoff die Papierbahn enthält, beispielsweise ob und in welcher Menge die Papierbahn Wasser enthält. Alternativ oder gleichzeitig kann dabei auch das Flächengewicht der Papierbahn ermittelt werden.

Gemäß einer besonders vorteilhaften Ausgestaltung der Erfindung für eine konkrete Ausführungsform des erfindungsgemäßen Verfahrens wird der Wassergehalt und/oder die Flächendichte einer Papierbahn nach folgender Gleichung ermittelt:

$$E = \epsilon\, N_1 + \beta\, N_2 + \gamma(T) \cdot N_2$$

Hierbei ist

E      die Kapazität

$\epsilon$      ein Maß für die Dielektrizitätskonstante des Papiers;

$N_1$      ein Maß für die Flächendichte;

$N_2$      ein Maß für den Feuchtegehalt;

$\beta/\gamma$      eine temperaturabhängige Material-Konstante von Wasser.

Vorteilhafterweise wird die Temperatur zur Ermittlung der temperaturabhängigen Konstanten gemessen, sei es parallel zum eigentlichen, durchzuführenden Prozess, sei es zur Ermittlung von Kalibrierungskurven, um für die jeweils herrschende Temperatur bekannte Materialkonstanten für die Gleichung zu haben.

Eine besonders vorteilhafte Ausgestaltung besteht auch darin, daß die Eigenschaften von Materialien mit polaren Molekülen durch die durch die Feldumkehr des periodischen Speisesignals hervorgerufenen Energieverluste ermittelt werden. Wie im weiterennoch ausgeführt werden wird, hängen die Energieverluste von der Art und/oder von der Quantität der polaren Moleküle ab, so daß aus dem durch die Energieverluste hervorgerufenen Kurvenverlauf des Antwortsignals Schlüsse auf die Art der polaren Moleküle, d.h. auf die Art des Stoffes und/oder die Menge des aus polaren Molekülen bestehenden Stoffes gezogen werden können.

Die Auswertung der Abfragewerte erfolgt vorzugsweise mit einem Mikroprozessor.

Die gestellte Aufgabe wird erfindungsgemäß auch durch eine Vorrichtung gelöst, bei der der Signal-Geber eine Signalformerschaltung und der Signal-Aufnehmer eine Abtastschaltung zum Abfragen des Antwortsignals an wenigstens einem diskreten, vorgegebenen Zeitpunkt während wenigstens einer Signalperiode aufweist. Mit der erfindungsgemäßen Vorrichtung ist es möglich, innerhalb einer Periode des periodischen Speisesignals einen Meßwert zur Verfügung zu haben. Ein Filter wie bei herkömmlichen Meßanordnungen ist nicht erforderlich. Die Meßgeschwindigkeit der erfindungsgemäßen Meßvorrichtung kann damit wesentlich gesteigert werden, und insbesondere ist es möglich, durch geeignete Wahl des Abfragezeitpunkts Imaginär- und Realteil getrennt zu ermitteln.

Vorzugsweise weist der Signalaufnehmer eine Sample-and-Hold-Schaltung auf, die es ermöglicht, etwa während einer Periode verschiedene Abtastwerte zu speichern und miteinander zu verknüpfen, beispielsweise daraus einen Mittelwert oder eine Differenz zur Ermittlung des Imaginär- bzw. Realteils abzuleiten.

Die Erfindung wird nachstehend anhand bevorzugter Ausführungsformen der Erfindung unter Bezug auf die Figuren beispielsweise näher erläutert. Es zeigen:

Fig. 1      eine schematische Schaltungsanordnung zur Durchführung des erfindungsgemäßen Meßverfahrens am Beispiel einer Differentialdrossel zur Wegmessung,

Fig. 2      ein Beispiel für eine Signalform des Speisesignals,

Fig. 3a      ein weiteres Beispiel für die Signalform des Speisesignals,

Fig. 3b      Signalverläufe von Antwortsignalen bei Beaufschlagen der Differentialdrossel mit dem in Fig. 3a dargestellten Speisesignal,

Fig. 4      ein Antwortsignal mit Abfrage-Zeitpunkten gemäß einer weiteren Ausführungsform der Erfindung,

Fig. 5      eine schematische Schaltungsanordnung zur Durchführung des erfindungsgemäßen Verfahrens am Beispiel einer Messung des Flächengewichts und/oder des Feuchtegehalts einer Papierbahn in einem Plattenkondensator,

Fig. 6a      ein Beispiel für eine Signalform des Speisesignals im Zusammenhang mit dem in Fig. 5 dargestellten Meßverfahren und

Fig. 6b      Signalverläufe von Antwortsignalen bei dem Meßverfahren gemäß Fig. 5.

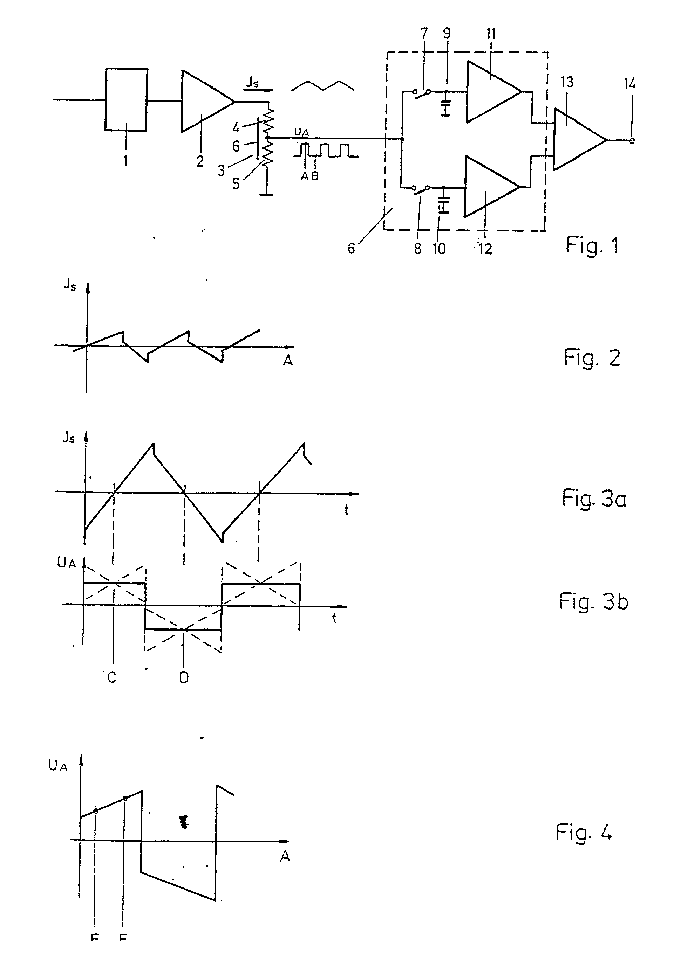

Die in Fig. 1 schematisch dargestellte Ausführungsform einer erfindungsgemäßen Meßanordnung weist eine Signalformerschaltung 1 mit einem nachgeschalteten Verstärker 2 auf, der einer Differentialdrossel 3 ein in dieser Ausführungsform dreieckiges Speisesignal $I_s$ bereitstellt. Der dreieckför-

mige Signalverlauf ist in Fig. 1 schematisch angedeutet.

Die Differentialdrossel 3 besteht aus zwei Spulen 4 und 5 sowie einem Kern 6, der bezüglich der Spulen 4 und 5 verschiebbar ist. Der dem Eingang des Spulenpaares 4, 5 abgewandte Anschluß der Spule 5 liegt an Masse, und der Verbindungspunkt der beiden Spulen 4 und 5 ist als Ausgangsleitung der Differentialdrossel 3 mit einer Sample- and-Hold-Schaltung 6 verbunden, die im dargestellten Ausführungsbeispiel zwei ge steuerte Schalter 7 bzw. 8 aufweist, mit denen das Antwortsignal $U_A$ abgetastet wird, um danach in einem jeweiligen Speicherkondensator 9 bzw. 10 gespeichert zu werden. Das abgetastete und gespeicherte Signal wird jeweils über einen Verstärker 11 bzw. 12 einem Differenzverstärker 13 zugeführt, an dessen Ausgang der Differenzwert der beiden abgetasteten Abfragewerte bereitgestellt wird.

Die Funktionsweise der in Fig. 1 dargestellten Meßanordnung gemäß der Erfindung wird nachfolgend erläutert. Mit dem Kern 6 der Differentialdrossel 3 ist ein nicht dargestellter Gegenstand, der der Wegmessung unterzogen werden soll, mechanisch verbunden. Bei einer Verschiebung des Gegenstands und damit auch des Kerns 6 der Differentialdrossel 3 ändern sich die Induktivitäten der Spulen 4 und 5 derart, daß sich die Induktivität der einen vergrößert und die der anderen verkleinert. Wird die Differentialdrossel mit einem dreieckförmigen Speisestrom $I_S$ versorgt, so ergibt sich gemäß der Formel

$$U = -L \frac{dI}{dt} \qquad (1)$$

ein Antwortsignal $U_A$ in Form einer rechteckförmigen Spannung, wie dies in Fig. 1 schematisch angedeutet ist. Bei dieser Betrachtung wurde zunächst idealerweise angenommen, daß die Spulen 4, 5 rein induktiv arbeiten und keine Ohm'schen Widerstände vorhanden sind. Weiterhin wurde idealerweise angenommen, daß magnetische Kernverluste nicht auftreten.

Die Schalter 7 und 8 werden nun so gesteuert, daß einer der Schalter 7 bzw. 8 zu einem Zeitpunkt während des hohen Pegels und der andere Schalter 8 bzw. 7 während des niederen Rechteckpegels des Antwortsignals $U_A$ in den leitenden Zustand versetzt wird, so daß mit der Sample- and-Hold-Schaltung 6 das Antwortsignal $U_A$ an den diskreten vorgegebenen Signalpunkten A und B abgetastet wird. Aus den abgetasteten Spannungswerten wird mit dem Differenzverstärker 13 die Differenz gebildet, die am Ausgang 14 anliegt und ern Maß für den Verschiebeweg des zu messenden Objekts darstellt.

Anhand von Fig. 1 wurde der in der Praxis nicht erreichbare Idealfall einer Differentialdrossel ohne Ohm'schen Widerstand und ohne magnetische Kernverluste beschrieben, bei dem ein dreieckförmiges Speisesignal $I_S$ ein rechteckförmiges Antwortsignal $U_A$ ergibt. Trotz der Tatsache, daß die Spulen 4, 5 der Differentialdrossel 3 auch einen Ohm'schen Widerstand darstellen - jeder Leiter hat nur einen endlichen Widerstand - und trotz zusätzlicher magnetischer Verluste im Kern 6 der Differentialdrossel 3 läßt sich ein rechteckförmiges Antwortsignal erreichen, wenn ein Speisesignal $I_S$ verwendet wird, das den genannten Verlusten in der Differentialdrossel 3 dadurch Rechnung trägt, daß dem primär-dreieckförmigen Speisesignal ein rechteckförmiges Speisesignal überlagert wird, um eine Mischform des Speisesignals $I_S$ zu schaffen. Ein derartiges Speisesignal $I_S$ als Mischform ist in Fig. 2 dargestellt. Der Rechteck- und Dreieckanteil des Speisesignals $I_S$ muß dabei so gewählt bzw. eingestellt werden, daß das Antwortsignal $U_A$ rechteckförmig ist. Andern sich die Ohm'schen Verluste in den Spulen 4 und 5 der Differentialdrossel 3 und/oder die magnetischen Verluste des Kerns 6 etwa durch Temperatureinflüsse, so muß der Rechteck- und Dreieckanteil des Speisesignals $I_S$ entsprechend verändert werden.

Gemäß einer alternativen Ausgestaltung der Erfindung ist es jedoch auch möglich, das Speisesignal $I_S$ konstant zu halten, also auf eine Rechteckform des Antwortsignals $U_A$ zu verzichten, und stattdessen die Kurvenform des Antwortsignals $U_A$ auszuwerten. Ein Beispiel für eine derartige Ausführungsform wird nachfolgend anhand der Fig. 3a und 3b beschrieben.

Das Speisesignal $I_S$ wird hinsichtlich seines Dreieck- und Rechteckanteils zunächst im wesentlichen so einjustiert, daß das Antwortsignal $U_A$ bei einer vorgegebenen, vorzugsweise mittleren Temperatur rechteckförmig ist. Das Speisesignal $I_S$ ist für diesen Fall in Fig. 3a dargestellt. Das dementsprechende Antwortsignal $U_A$ ist in Fig. 3b durch eine ausgezogene Linie wiedergegeben.

Steigt die Temperatur an, nehmen auch die Ohm'schen Verluste zu, so daß bei unverändertem, konstantem Speisesignal $I_S$ entsprechend Fig. 3a ein Signalverlauf des Antwortsignals $U_A$ entsteht, der in Fig. 3b gestrichelt dargestellt ist. Nimmt dagegen die Temperatur der Spulen 4, 5 der Differentialdrossel 3 ab und verringern sich dadurch die Ohm'schen Verluste in den Spulen 4 und 5, ergibt sich bei konstantem Speisesignal $I_S$ gemäß Fig. 3a ein Signalverlauf des Antwortsignals $U_A$ wie er in Fig. 3b strich-punkt-liniert wiedergegeben ist.

Wählt man nun den diskreten Zeitpunkt für das Abtasten des Abfragewerts in der Weise, daß er im Schnittpunkt der drei Kurvenverläufe liegt, so sind die Abfragewerte unabhängig von Temperatur- oder sonstigen Änderungen, die in den Spulen und/oder im Kern der Differentialdrossel 3 auftreten können.

Der physikalische Hintergrund dieses Sachverhalts ist der, daß zu dem in dieser Weise gewählten Abtastzeitpunkt das periodische Speisesignal $I_S$ durch Null geht und daher in der Spule kein Strom fließt, was bedeutet, daß auch keine Ohm'schen Verluste auftreten können. Diese erfindungsgemäße Ausgestaltung der Erfindung ist von besonderem Vorteil, da also zu den in der genannten Weise gewählten Zeitpunkten für die Abtastung, an denen das Speisesignal $I_S$ durch Null geht, auf einfache Weise nur der Imaginärteil des komplexen Widerstands unabhängig von Realteil gemessen werden kann. Bei dieser Messung bleibt also der sich durch Temperaturschwankungen ändernde Realteil unberücksichtigt. Dadurch ist mit dieser sehr vorteilhaftenerfindungsgemäßen Maßnahme auf einfachste Weise eine Temperaturkompensation bei der Messung erreichbar.

Anhand von Fig. 4 wird eine weitere Abwandlung des erfindungsgemäßen Verfahrens erläutert. Anstelle der Abfrage des Antwortsignals $U_A$ zum Zeitpunkt des Nulldurchgangs des Speisesignals $I_S$ wird das beispielsweise auf Grund von Temperatureinflüssen nicht mehr korrekt rechteckförmige Antwortsignal $U_A$ während des nunmehr nicht mehr waagerechten, sondern geneigten Kurvenverlaufs wenigstens an zwei Zeitpunkten E und F abgefragt. Durch Bildung des Mittelwerts der an den Zeitpunkten E und F abgefragten Signalwerte ergibt sich der Imaginärteil und durch Bildung der Differenz aus den ermittelten Abfragewerten ergibt sich der Realteil des komplexen Widerstands. Auf diese Weise ist es ebenfalls möglich, sowohl den Real- als auch den Imaginärteil des komplexen Widerstands auf einfache Weise getrennt voneinander zu ermitteln, so daß auch bei dieser vorteilhaften Ausführungsform der Erfindung beispielsweise wiederum eine Kompensation eines Temperaturgangs oder eine sonstige Meßwertkompensation auf einfachste Weise durchgeführt werden kann.

Beim Einsatz der vorliegenden Erfindung im Zusammenhang mit Kapazitätsgebern muß lediglich die zuvor genannte Formel (1) durch die Formel

$$I = C \frac{dU}{dt} \qquad (2)$$

ersetzt werden, wobei I die Stromstärke, C die Kapazität und U die Spannung ist. Statt eines dreieckförmigen Stroms muß in diesem Falle eine dreieckförmige Spannung eingespeist werden und statt eines rechteckförmigen Ausgangssignals wird ein rechteckförmiger Ausgangsstrom als Antwortsignal abgefragt bzw. ausgewertet.

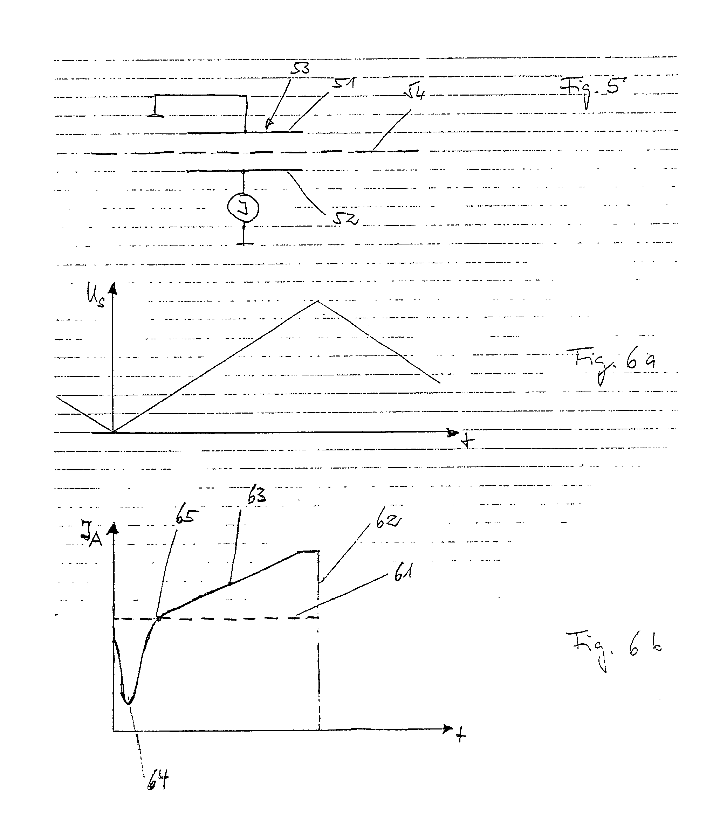

Ein weiteres, für praktische Meßzwecke besonders vorteilhaftes Ausführungsbeispiel der Erfindung wird nachfolgend anhand der Figuren 5 bis 8 beschrieben. Zwischen den beiden Kondensatorplatten 51 und 52 eines Kondensators 53 läuft kontinuierlich eine Papierbahn 54, deren Feuchtegehalt und/oder Flächendichte kontinuierlich gemessen werden soll. Der Kondensator wird mit einer periodischen dreieckförmigen Spannung beaufschlagt, die in Fig. 6a dargestellt ist. Der zu messenden Antwortstrom ergibt sich aus der Gleichung

$$I = C \frac{dU}{dt} + \frac{1}{R} \cdot U, \qquad (3)$$

die gegenüber der Gleichung (2) durch das Glied $(1/R) \cdot U$ ergänzt ist, welches einen ohm'schen Widerstand oder einen einem ohm'schen Widerstand entsprechenden Energieverlust berücksichtigt.

Weist die den Plattenkondensator 51 durchlaufende Papierbahn keine Wassermoleküle auf, ist die Papierbahn also trocken, so ergibt sich im Idealfall bei Beaufschlagen des Plattenkondensators 51 mit einer dreieckförmigen Speisespannung $U_s$ ein rechteckförmiger Verschiebestrom $I_A$ als Antwortsignal, wie er in Fig. 6b durch die Kurve 61 dargestellt ist.

Enthält die Papierbahn dagegen Wassermoleküle, ist also das Papier feucht, so addiert sich zu der Papierkapazität die Kapazität der Wassermoleküle. Da die Wassermoleküle jedoch stark polar sind, entziehen sie dem elektrischen Feld des Kondensators 51 Energie aufgrund der Brown'schen Molekularbewegung und/oder der Umpolarisation.

In Fig. 6b ist der Verschiebestrom $I_A$ als Kurve 62 für den Fall eingezeichnet, daß die Papierbahn Wassermoleküle enthält, also feucht ist. Bei der Feldumkehr müssen die polaren Wassermoleküle umpolarisiert werden, was eine relativ hohe Energie beansprucht. Dem Kondensatorfeld wird daher viel Energie entzogen, so daß der Verschiebestrom $I_A$ stark abfällt. Dies ist in Fig.6b durch den starken Einbruch 64 der Verschiebestromkurve zu Beginn einer Halbperiode ersichtlich. Neben der Energie zur Umpolarisierung entziehen die Wassermoleküle dem Feld weiterhin Energie durch ihre thermische Bewegung entsprechend der Clausius Mosotti-Gleichung. Dies wiederum bedeutet ebenfalls Verluste ähnlich denen, wie sie in einem Widerstand entstünden, der parallel zum Plattenkondensator 51 gelegt wäre. Dadurch wird dem rechteckförmigen Verschiebestrom ein dreieckförmiger Strom überlagert, der sich in Fig. 6b durch den im wesentlichen kontinuierlich ansteigenden Kurvenabschnitt 63 ausdrückt, und der in Gleichung (3) durch das Glied $(1/R) \cdot U$ ausgedrückt ist. Dieser Kurvenverlauf ist abhängig von der Temperatur und dem Dipolmoment des Moleküls. Durch die Messung von zwei Werten des Antwortstroms $I_A$ im Bereich 63 der im wesentlichen kontinuierlich ansteigenden Kurve kann die Kurvensteigung in diesem Bereich ermittelt und dadurch können die Energieverluste im Plattenkondensator 51 bestimmt werden. Die Kapazität des Kondensators ist durch folgende Gleichung gegeben:

$$E = \epsilon N_1 + \beta N_2 + \gamma(T) \cdot N_2 \qquad (4)$$

Hierbei ist

| | |
|---|---|
| E | die Kapazität; |
| $\epsilon$ | ein Maß für die Dielektrizitätskonstante des Papiers; |
| $N_1$ | ein Maß für die Flächendichte; |
| $N_2$ | ein Maß für den Feuchtegehalt; |
| $\beta/\gamma$ | eine temperaturabhängige Material-Konstante von Wasser. |

Um die temperaturabhängige Materialkonstante des Wassers für die auftretenden Temperaturen zu bestimmen, kann zusätzlich zu den beschriebenen Messungen jeweils auch eine Temperaturmessung durchgeführt werden, oder es können Kurven der Materialkonstanten $\gamma$ in Abhängigkeit der Temperatur aufgestellt werden. Da die Kapazität des Plattenkondensators 51 durch seine Stromaufnahme gemessen werden kann, ist es mit der Gleichung (4) möglich, die Flächendichte und/oder den Feuchtegehalt der zu prüfenden Papierbahn kontinuierlich und aus den bereits früher beschriebenen Gründen sehr schnell zu ermitteln.

Selbstverständlich ist es auch im Zusammenhang mit diesem Ausführungsbeispiel möglich, aus den zuvor beschriebenen Gründen diskrete Zeitpunkte für das Abtasten der Abfragewerte, etwa bei Null-Durchgängen zu wählen, oder weitere Maßnahmen zu treffen, um Temperaturkompensation bei den Messungen zu erreichen, wie dies zuvor anhand alternativer Ausführungsbeispiele bereits beschrieben wurde.

Das erfindungsgemäße Meßverfahren gemäß des anhand der Fig. 5 und 6 beschriebenen Ausführungsbeispiels ist jedoch nicht auf ein Verfahren zur Messung der Feuchte und/oder des Flächengewichts von Papier beschränkt. Vielmehr ist es mit dem erfindungsgemäßen Verfahren möglich, auch die Eigenschaften anderer Stoffe und Materialien, die polare Moleküle aufweisen, bzw. deren Menge schnell und zuverlässig zu bestimmen. Insbesondere durch die durch die Feldumkehr des Speisesignals hervorgerufenen Energieverluste, wie in Fig. 6 durch den Einbruch 64 der Kurve 62 deutlich wird, ist es möglich, das Dipolmoment bzw. die Art der polaren Moleküle und damit der zu untersuchenden Materialien festzustellen. Besonders vorteilhaft ist dabei die Möglichkeit, die Dipolstärke des Stoffers festzustellen, nämlich durch die Lage des Schnittpunktes 65 der Kurve 6l (Verschiebestrom ohne Dipole) mit der Kurve 62 (Verschiebestrom mit Dipolen). Es ergibt sich dadurch das Verhältnis $\beta : \gamma$. Ist der Schnittpunkt 65 weiter rechts, ist die Dipolstärke größer, ist der Schnittpunkt 65 weiter links, ggf. auch links von der Ordinate, ist die Dipolstärke kleiner.

Die Anwendung der erfindungsgemäßen Merkmale im Zusammenhang mit Widerstandsgebern ist ebenfalls ohne weiteres möglich. In diesem Falle wird der Widerstandsgeber mit einer rechteckförmigen Spannung beaufschlagt. Die zuvor anhand von Induktiv- und Kapazitivgebern erläuterten erfinderischen Maßnahmen sind daher auch in identischer Weise auf Widerstandsgeber anwendbar.

Wichtige Merkmale der Erfindung können wie folgt zusammengefaßt werden:

1. Verfahren zum Messen physikalischer Größen, bei dem ein periodisches Speisesignal abgegeben und ein Antwortsignal ausgewertet wird, wobei das Speisesignal eine vorgegebene Signalform aufweist, und wobei das Antwortsignal während wenigstens einer Signalperiode an wenigstens einem diskreten Zeitpunkt abgefragt wird, und der wenigstens eine diskrete Abfragewert ausgewertet wird.

2. Verfahren nach Punkt 1, wobei der Abfragezeitpunkt in zeitlichem Bezug zum Speisesignal gewählt ist.

3. Verfahren nach Punkt 1 oder 2, wobei der Abfragezeitpunkt in zeitlichen Bezug zu einem Nulldurchgang des Speisesignals steht.

4. Verfahren nach einem der vorhergehenden Punkte, wobei das Antwortsignal beim Nulldurchgang des Speisesignals abgefragt wird.

5. Verfahren nach einem der vorhergehenden Punkte, wobei das Speisesignal eine im wesentlichen dreieckförmige periodische Spannung ist.

6. Verfahren nach einem der Punkte 1 bis 4, wobei das Speisesignal ein im wesentlichen dreieckförmiger, periodischer Strom ist.

7. Verfahren nach einem der Punkte 1 bis 4, wobei das Speisesignal eine im wesentlichen rechteckförmige Spannung ist.

8. Verfahren nach einem der vorhergehenden Punkte, wobei das Speisesignal eine Mischform ist.

9. Verfahren nach einem der vorhergehenden Punkte, wobei das Speisesignal trapezförmig ist.

10. Verfahren nach einem der vorhergehenden Punkte, wobei die Form des Speisesignals so gewählt und/oder geändert wird, daß das Antwortsignal rechteckförmig ist bzw. bleibt.

11. Verfahren nach einem der Punkte 1 bis 9, wobei die Form des Antwortsignals ausgewertet wird.

12. Verfahren nach einem der vorhergehenden Punkte, wobei das Antwortsignal während einer Periode des Speisesignals an mehreren Zeitpunkten abgefragt wird.

13. Verfahren nach einem der vorhergehenden Punkte, wobei das Antwortsignal während wenigstens einer Periode an wenigstens zwei Punkten abgefragt, und die Abfragewerte gemittelt und/oder die Differenz aus den Abfragewerten gebildet wird.

14. Verfahren nach einem der vorhergehenden Punkte, wobei die Abfragewerte zur Ermittlung von Materialeigenschaften ausgewertet werden.

15. Verfahren nach Punkt 14, wobei die Art des Materials durch Auswertung der Abfragewerte ermittelt wird.

16. Verfahren nach Punkt 14 oder 15, wobei die Quantität des Materials durch Auswertung der Abfragewerte ermittelt wird.

17. Verfahren nach einem der vorhergehenden Punkten, wobei das zu prüfende Material in einen Plattenkondensator gebracht wird, der mit einer dreieckförmigen Spannung beaufschlagt wird.

18. Verfahren nach Punkt 17, wobei das Material den Plattenkondensator kontinuierlich durchläuft.

19. Verfahren nach einem der vorhergehenden Punkte, wobei eine Papierbahn durch den Plattenkondensator geführt wird.

20. Verfahren nach Punkt 19, wobei das Flächengewicht der Papierbahn gemessen wird.

21. Verfahren nach Punkt 19 oder 20, wobei der Wassergehalt der Papierbahn gemessen wird.

22. Verfahren nach einem der Punkte 19 bis 21, wobei der Wassergehalt und/oder die Flächendichte der Papierbahn nach folgender Gleichung ermittelt wird:

$$E = \epsilon\, N_1 + \beta\, N_2 + \gamma(T) \cdot N_2$$

Hierbei ist

E      die Kapazität;

$\epsilon$      ein Maß für die Dielektrizitätskonstante des Papiers;

$N_1$      ein Maß für die Flächendichte;

$N_2$      ein Maß für den Feuchtegehalt;

$\beta/\gamma$      eine temperaturabhängige Material-Konstante von Wasser.

23. Verfahren nach einem der Punkte 19 bis 22, wobei die Temperatur zur Ermittlung der temperaturabhängigen Konstanten gemessen wird.

24. Verfahren nach einem der vorhergehenden Punkte, wobei die Eigenschaften von Materialien mit polaren Molekülen durch die durch die Feldumkehr des Speisesignals hervorgerufenen Energieverluste ermittelt werden.

25. Verfahren nach einem der vorhergehenden Punkte, wobei die Auswertung der Abfragewerte mit einem Mikroprozessor erfolgt.

26. Vorrichtung zur Durchführung des Verfahrens nach einem der Punkte 1 bis 14, mit einem Signalgeber und einem Signalaufnehmer, wobei der Signalgeber eine Signalformerschaltung (1) und der Signalaufnehmer eine Abtastschaltung (6) zum Abfragen des Antwortsignals während wenigstens einer Signalperiode an wenigstens einem diskreten Zeitpunkt aufweist.

27. Vorichtung nach Punkt 15, wobei der Signal-Aufnehmer eine Sample- and-Hold-Schaltung (6) aufweist.

## Patentansprüche

1. Verfahren zum Messen physikalischer Größen, bei dem ein periodisches Speisesignal abgegeben und ein Antwortsignal ausgewertet wird, **dadurch gekennzeichnet,** daß das Speisesignal eine vorgegebene Signalform aufweist, und daß das Antwortsignal während wenigstens einer Signalperiode an wenigstens einem diskreten Zeitpunkt abgefragt wird, und der wenigstens eine diskrete Abfragewert ausgewertet wird.

2. Verfahren nach Anspruch 1, dadurch gekennzeichnet, daß der Abfragezeitpunkt in zeitlichem Bezug zum Speisesignal gewählt ist.

3. Verfahren nach Anspruch 1 oder 2, dadurch gekennzeichnet, daß der Abfragezeitpunkt in zeitlichen Bezug zu einem Nulldurchgang des Speisesignals steht.

4. Verfahren nach einem der vorhergehenden Ansprüche, dadurch gekennzeichnet, daß das Antwortsignal beim Nulldurchgang des Speisesignals abgefragt wird.

5. Verfahren nach einem der vorhergehenden Ansprüche, dadurch gekennzeichnet, daß das Speisesignal eine im wesentlichen dreieckförmige periodische Spannung ist.

6. Verfahren nach einem der Ansprüche 1 bis 4, dadurch gekennzeichnet, daß das Speisesignal ein im wesentlichen dreieckförmiger, periodischer Strom ist.

7. Verfahren nach einem der Ansprüche 1 bis 4, dadurch gekennzeichnet, daß das Speisesignal eine im wesentlichen rechteckförmige Spannung ist.

8. Verfahren nach einem der vorhergehenden Ansprüche, dadurch gekennzeichnet, daß das Speisesignal eine Mischform ist.

9. Verfahren nach einem der vorhergehenden Ansprüche, dadurch gekennzeichnet, daß das Speisesignal trapezförmig ist.

10. Verfahren nach einem der vorhergehenden Ansprüche, dadurch gekennzeichnet, daß die Form des Speisesignals so gewählt und/oder geändert wird, daß das Antwortsignal rechteckförmig ist bzw. bleibt.

Fig. 1

Fig. 2

Fig. 3a

Fig. 3b

Fig. 4

EP 0 438 103 A2

Fig. 5

Fig. 6 a

Fig. 6 b

11